(19) Europäisches Patentamt
European Patent Office
Office européen des brevets

(11) Publication number: 0 163 202 B1

# (12) EUROPEAN PATENT SPECIFICATION

(45) Date of publication of patent specification: 06.02.91

(51) Int. Cl.$^5$: G 03 F 7/42

(21) Application number: 85105992.3

(22) Date of filing: 15.05.85

## (54) Photoresist stripper and stripping method.

(30) Priority: 21.05.84 US 612596

(43) Date of publication of application: 04.12.85 Bulletin 85/49

(45) Publication of the grant of the patent: 06.02.91 Bulletin 91/06

(84) Designated Contracting States: DE FR GB IT

(56) References cited:
EP-A-0 075 328
EP-A-0 075 329
EP-A-0 102 629
EP-A-0 103 808
FR-A-2 366 350
US-A-3 928 065

(73) Proprietor: SHIPLEY COMPANY INC.
2300 Washington Street
Newton, Massachusetts 02162 (US)

(72) Inventor: Martin, Robert
600 Hollis Street
Framingham Massachusetts 01701 (US)
Inventor: Perkins, Majorie
Stonehill Drive
Stoneham Massachusetts 02180 (US)

(74) Representative: Leiser, Gottfried, Dipl.-Ing. et al
Patentanwälte Prinz, Leiser, Bunke & Partner
Manzingerweg 7
D-8000 München 60 (DE)

EP 0 163 202 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

This invention relates to a stripper for positive working photoresist and its use for removing developed positive photoresist from the surface of a substrate.

Where a pattern is to be formed on a substrate, such as metallic circuitry in the manufacture of printed circuit boards and integrated circuits, it can either be put down selectively in the appropriate areas such as by plating, or it can be put down over the entire substrate and selectively removed by chemical etching. A method well known in the art for forming a selective pattern involves forming a layer of resist over a substrate that may be uncoated or coated with a metal, (hereinafter collectively referred to as "substrate"), in those areas to be shielded from metal deposition or metal removal, dependent upon the process of manufacture employed. Typically, the resist layer is a polymer that is substantially unaffected by the metal deposition or metal removal process, and thus is able to protect the underlying areas of the substrate. For this purpose, various photoresists are known, that is, substances which form the desired masking pattern on the substrate upon exposure to activating light through a photographic image. Photoresists are generally of two types, positive photoresists and negative photoresists. Prior to exposure to activating light, x-ray or electron beam radiation, a positive resist is insoluble in a developer solution. Upon exposure, the light struck portion of the photoresist becomes soluble in the developer while the unexposed areas remain insoluble. Upon development, usually in aqueous basic solution, the solubilized portions are removed, leaving the insoluble portions of the resist layer on the substrate in the pattern of the photographic image.

Negative acting photoresists are chemically distinct from positive resists, and become insolubilized upon exposure to activating light. Negative photoresists are, for example, cyclicized rubber-based resists, while positive photoresists typically comprise, for example, a novolak resin rendered insoluble in base solution by addition of a light-sensitive material to the novolak known in the art as an inhibitor. Upon exposure to actinic radiation, the light-sensitive material is chemically altered, and is converted by exposure from a dissolution inhibitor to a dissolution accellerator. Other types of both positive and negative photoresists are also known.

Subsequent to depositing or removing metal or oxide layers on the exposed portions of the substrate, the resist layer must be removed or stripped from the surface. The removal process must not adversely affect either the substrate nor the metal layer. The substrate can be a silicon dioxide coated silicon wafer, as in the manufacture of semiconductor microcircuitry where the metallic microcircuitry is typically aluminum or an aluminum alloy. Other materials used in I.C. manufacture, or used for example in the manufacture of printed circuit boards, include a variety of inorganic substrate materials such as garnet crystal, L.E.D. and L.C.D. surfaces; e.g. indium oxide, iron oxide, chrome and virtually every other metal. The means employed for stripping the resist must act without corroding, dissolving, or dulling the surface of such materials, and without chemically altering the material of the substrate.

Prior art methods for removing positive photoresists include the use of organic stripping compositions comprising phenol and linear alkyl benzene sulfonic acids, as exemplified in U.S. Patent No. 3,871,929. Other known organic stripping compositions contain organic sulfonic acids of the formula $R—SO_3H$, where R is an organic radical; an organic solvent; fluoride ion; and optionally, phenol, as disclosed in U.S. Patent No. 4,165,295. Prior art inorganic stripping compositions also include aqueous sulfuric acid compositions containing fluoride ion, as exemplified in U.S. Patent No. 3,932,130, U.S. Patent No. 3,654,001 and U.S. Patent No. 3,080,071.

The above-mentioned stripping compositions create problems during use because of their tendency to etch silicon dioxide substrates, which effect is likely caused by the acidity or basicity of the composition. The organic stripping compositions cause undesirable dulling of the surface of aluminum circuitry over the substrate, or undesirable etching of a silicon dioxide substrate. Stripping compositions containing phenolics are undesirable in that phenolics are toxic, poorly waste-treatable, and can actually lower striping efficiency when employed in compositions for stripping positive-type photoresists. The use of phenol-type strippers is rapidly becoming untenable due to environmental considerations [L. H. Kaplan and B. K. Bergin, *J. Electrochemical Soc.*, 127, 386 (1980)].

Many known stripping compositions are insufficiently effective against certain resists because their rate of attack or dissolution on the resist is too slow. In particular, known stripping compositions are insufficiently effective against those resists which, during the course of device manufacture, have been subjected to elevated temperatures, such as during an exceptionally high temperature post-bake, to high energy processing, such as during ion implantation, or to exceptionally harsh chemical environments. This decreases their usefulness generally, and restricts the flexibility of processing lines in which they are used.

US—A—3 928 065 discloses detergent compositions in fine particulate form suitable for use in removing adhering carbonized food debries from metal surfaces comprising in admixture (a) a mixture of lactams such as N-methyl-2-pyrrolidone, N-ethyl-2-pyrrolidone, and N-isopropyl-2-pyrrolidone, and (b) powdered kaolin. These known compositions are said to be also useful as a hand cleaner. The patent does not disclose a stripping composition of stripping positive working photoresist from a substrate.

It is an object of the present invention to provide a stripper for positive working photoresist having improved properties comprising improved effectivity and increased rate of attack on or dissolution and removal of the resist.

The stripper of the present invention comprises a solution of a mixture of lactams where a first lactam is present in a concentration of at least 60 percent by weight of the stripping compositions and one or more additional lactams, differing from the frist lactam, comprises the balance of the lactams.

The subject invention is based upon the discovery that compositions having a lactam structure are effective strippers for positive resists and do not possess the disadvantages of prior art strippers as described above. Moreover, it is a discovery of the invention that though lactams strip photoresist from a substrate at a reasonable rate comparable to strippers of the prior art, the rate of removal can be significantly increased by use of a solution containing more than one lactam where the several lactams in solution differ from each other.

The strippers of the invention are especially useful for stripping exposed resists from a substrate coated with a positive working, alkali soluble resist, and are believed to be useful for stripping other resists as well as E. beam resists based upon such polymers as polymethyl methacrylate; beeswax based resists; and polyimide type resists.

The strippers of the invention are also especially useful for stripping resist from a silicon dioxide substrate as the strippers are essentially neutral and consequently, do not etch the silicon dioxide while stripping the resist.

The strippers of the invention are used to remove positive working resists from a substrate. The positive working resists comprise a light sensitive compound in a film-forming polymer binder. The light sensitive comounds, or inhibitors or sensitizers as they are often called, most frequently used are esters and amides formed from o-quinone diazide sulfonic acids. These esters and amides are well known in the art and are described by W. S. DeForest, *Photoresist Material and Processes*, McGraw Hill, Inc. New York, pages 47—55, (1975), incorporated herein by reference. These light sensitive compounds, and the methods used to make the same, are all well documented in prior patents including German Patent No. 865,140 granted February 2,1953 and U.S. Patents Nos. 2,767,092; 3,046,110; 3,046,112, 3,046,119; 3,046,121; 3,046,122 and 3,106,465, all incorporated herein by reference. Additional sulfonic amide sensitizers that have been used in the formulation of positive acting photoresists are shown in U.S. Patent No. 3,637,384, also incorporated herein by reference. These materials are formed by the reaction of a suitale diazide of an aromatic sulfonyl chloride with an appropriate rosin amine. Methods for the manufacture of these sensitizers and examples of the same are shown in U.S. Patent No. 2,797,213 incorporated herein by reference. Other positive working diazo compounds have been used for specific purposes. For example, a diazo compound used as a positive working photoresist for deep U.V. lithography is Meldrum's diazo and its analogs as described by Clecak et al., *Technical Disclosure Bulletin*, Volume 24, Number 4, September 1981, IBM Corporation, pp. 1907 and 1908. An o-quinone diazide compound suitable for laser imaging is shown in U.S. Patent No. 4,207,107. The aforesaid references are also incorporated herein by reference.

The resin binder most frequently used with the o-quinone diazides in commercial practice are the alkali soluble phenol formaldehyde resins known as the Novolak resins. Photoresists using such polymers are illustrated in U.K. Patent No. 1,110,017 incorporated herein by reference. These materials are the product of reaction of a phenol with formaldehyde under conditions whereby a thermoplastic polymer is formed with a melting point of about 120°C. Novolaks with melting points in excess of 120°C are known but are not generally used in photoresist formulations because they are often brittle or have other properties limiting their use.

Another class of binders used with both the negative acting aromatic azides and the positive acting o-quinone diazides are the homopolymers and copolymers of vinyl phenol. Photoresists of this nature are disclosd in U.S. Patent No. 3,869,292, supra. It is believed that photoresists using binders of polymers formed from vinyl phenols have not found extensive use in commerce.

In the prior art, the above described positive resists using novolak resins as a binder are most often used as masks to protect substrates from chemical etching in photo-engraving processes. For example, in a conventional process for the manufacture of a printed circuit board, a copper-clad substrate is coated with a layer of a positive working photoresist, is exposed to actinic radiation to form a latent circuit image in the photoresists coating, developed with a liquid developer to form a relief image and etched with a chemical etchant whereby unwanted copper is removed and copper protected by the photoresist mask is left behind in a circuit pattern. For the manufacture of printed circuit boards, the photoresist must possess chemical resistance, must adhere to the circuit board substrate and for high density circuits, must be capable of fine line image resolution.

Similar photoresists are also used in the fabrication of semiconductors. As in the manufacture of printed circuits, the photoresist is coated onto the surface of a semiconductor wafer and then imaged and developed. Following development, the wafer is typically etched with an etchant whereby the portions of the wafer bared by the development of the photoresist are dissolved while the portions of the wafer coated with photoresist are protected, thereby defining a circuit pattern. For use in the manufacture of a semiconductor, the photoresist must possess resistance to chemical etchants, must adhere to the surface of the semiconductor wafer and must be capable of very fine line image resolution.

Recent developments in photoresist technology involve processes where high temperatures are encountered. For example, a recent development in the fabrication of semiconductors substitutes dry plasma etching for wet chemical etching to define a circuit. Plasma etching provides advantages over wet chemical etching in that it offers process simplification and improves dimensional resolution and tolerance.

However, the demands on the resists are significantly greater when using plasma etching. For both wet etching and plasma etching, the resist must adhere to the substrate and must be capable of fine line image resolution. For plasma etching, in addition to these properties, the resist must often be capable of withstanding high temperatures without image deformation and without eroding as plasma etching generates high temperatures at the wafer surface.

When photoresists are heated to elevated temperatures to improve their adhesion to substrates and their resistance to chemical etchants, they become increasingly more difficult to remove from a substrate. Consequently, the time to remove or strip the photoresist from the substrate is increased resulting in an overall increase in the processing time to manufacture an electronic device. The strippers of the invention are capable of stripping photoresists at a more rapid rate than prior art strippers and consequently, the processing time required to manufacture an electronic device is reduced.

The strippers of the invention comprise a solution containing a mixture of lactams where each lactam in the mixture conforms to the structural formula:

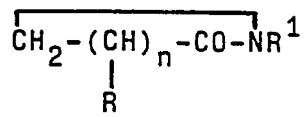

where n is a whole integer of from 1 through 3, and the R on each methylene group, individually, is selected from the group of hydrogen, a polar group such as hydroxy, carboxyl, sulfoxy, etc., lower alkyl or lower alkyl substituted with a polar group and $R^1$ is selected from the group of hydrogen, lower alkyl, including cycloalkyl, either unsubstituted or substituted with a polar group and aryl. The preferred lactams in accordance with the invention are pyrrolidones — i.e, where in the above formula, n is 1 and R is hydrogen.

Examples of suitable lactams include the following: butyrolactams

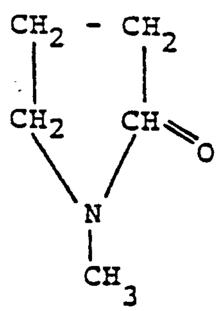

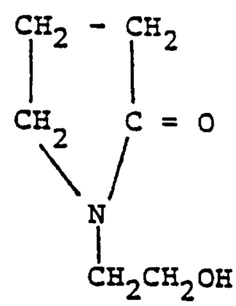

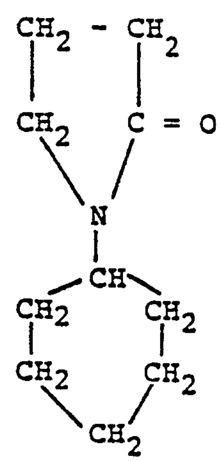

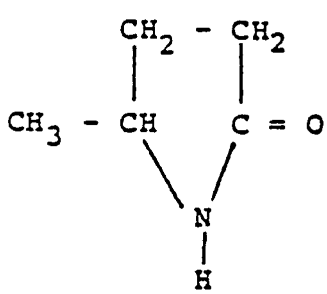

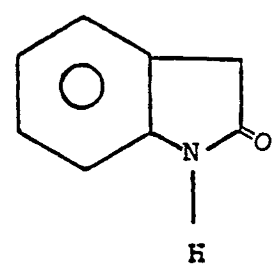

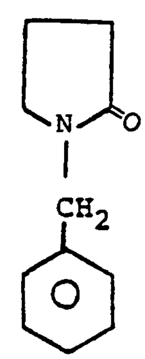

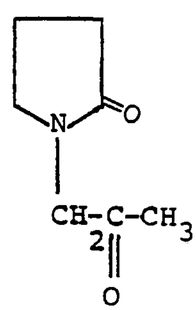

valerolactams

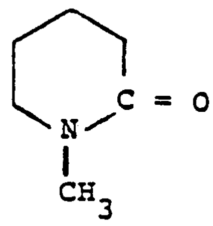

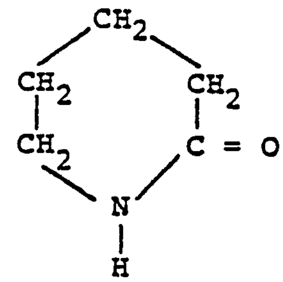

caprolactams

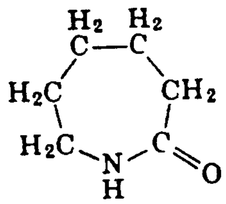

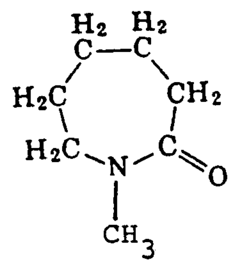

To enhance the rate of removal of photoresists from a substrate, the lactam solution contains a mixture of lactams: e.g., two or more lactams where each conforms to one of the above general formulas, with one of the lactams comprising at least 60% by volume of the total solution and the remaining lactams, differing from the first, comprise the balance. Preferably, the first lactam is present in an amount of from 90 to 99% by volume of the solution and the remaining lactams comprise the balance. In this respect, it has been found that the rate of removal of photoresist increases rapidly from about 1% of the second lactam in solution up to a maximum at between about 3 to 8%, dependent upon the specific mixture and photoresist used. Thereafter, as the concentration of the second lactam increases above about 10%, the rate photoresist removal drops off and decreases down to a rate equivalent to the rate obtainable with a single lactam. Typically, the rate of removal of photoresist using the mixed lactam solution is at least one and one half times the rate obtainable with either lactam used alone.

In addition to an increased rate of removal, the stripping compositions of the invention also provide a significant advantage in waste treatment since the preferred compositions do not contain phenolic compounds. In addition, the preferred lactams employed in the stripping composition of the invention are liquid at room temperature, thereby facilitating handling, and they are miscible with numerous solvents including, for example, water, alcohol, xylene, acetone, etc.

In addition to the above advantages, the absence of metal ions in the lactam mixture precludes metalion contamination of substrates during the stripping process, and also renders the stripping compositions more easily waste treatable. Another advantage of the lactam mixture of the invention is that the solutions are essentially neutral in pH whereby attack on acid or alkali senstive materials is avoided.

The stripping solutions of the invention effectively remove positive photoresists faster and at lower temperatures than other known organic stripping compositions. The rate of attack on metals such as aluminum, oxides and other inorganic substrate materials, including silicon and silicon dioxide, is significantly less than that of other stripping compositions.

As would be apparent to those skilled in the art, other ingredients may be added to the stripping solutions to adapt them to particular applications, such as dyes or colorants, or a wetting agent as would be known to the art. For most applications however, such as in the manufacture of integrated circuits employing aluminum over silicon and silicon dioxide substrates, and in the manufacture of printed circuit boards, the addition of a wetting agent has not been found to be necessary and has not been observed to significantly effect the efficacy of the stripping solution.

Where a positive photoresist is soft-baked after development, that is where the casting solvents are driven off at temperatures of about 90°C, but the resist resin components remain otherwise substantially unaltered, the present stripping compositions can be used effectively even at temperatures as low as room temperature. Where the resist is hard-baked (120°C to 200°C), where thermal cross-linking may occur, the stripping solution can be used at temperatures of about 50°C to 150°C, and preferably at temperatures varying between about 80°C and 90°C. Lower temperatures can be used with longer stripping times.

It is believed that the stripping compositions of the invention may be useful for stripping positive photoresists even when used in conjunction with ion-implanting techniques in the manufacture of integrated circuits. Other known stripping compositions require much longer, often many hours longer, to

strip such resists and often do not remove the resist at all. Using the present stripping composition, the resist is removed cleanly an without residue, and a simple water rinse completely removes the stripping solution from the work piece.

In addition to novel stripping solutions, the present invention e.g. provides a method for using the solutions to remote a positive photoresist from a substrate. In a preferred mode of the invention, a device to be stripped of positive photoresist is immersed in the novel stripping solution of the invention, at a temperature as described above, preferably, 80°C to 90°C. The solution is stirred or otherwise agitated. The device is contacted with the stripping solution either continuously, which is preferred, or intermitently, typically for sufficient time to completely remove the resist. In an alternative mode of operation, the device to be stripped of resist can be contacted with the stripping composition as a spray.

It should be noted that the stripping method and stripping composition of the invention are not limited to the foregoing temperature or concentration ranges, but rather will be effective, though perhaps less so, outside of the preferred ranges.

The stripping solutions of the invention provide another advantage since, in contrast to its excellent efficacy in the removal of positive photoresist, it does not significantly remove certain materials such as cured or partially cured polyimides and cyclized resist. Accordingly, the stripping solutions of the invention can be used to remove one or more layers of positive resist while leaving one or more layers of such materials intact over the substrate. Thus, the stripping solutions can be used in conjuction with bi-layer and multi-layer masking techniques to simplify and improve the manufacture of, for example, integrated circuits and printed circuit boards.

It should be understood that while the novel stripping solutions of the invention are most notable for their surprising efficacy in stripping of positive photoresists, there is no intent to exclude from the scope of the invention its use to strip any negative photoresist or other masking layer strippable by the stripping compositions of the invention.

The following examples will better illustrate the invention and are not to be considered as limitations on the scope thereof.

Example 1

Silicon wafers, three inches in diameter, were coated with MICROPOSIT—1450J Photoresist (Shipley Company Inc., Newton, MA.), using conventional techniques. Two solutions were prepared, the first comprising N-methyl-2-pyrrolidone (NMP) and the second consisting of a mixture of 95 parts NMP and 5 parts N-(2-hydroxyethyl)-2-pyrrolidone (NHEP). Both solutions were maintained at 80°C with magnetic stir bar agitation at slow speed. The silicon wafers were coated and baked at 150°C for 30 minutes to yield a final film thickness of 1.1 um. The so formed films were stripped of resist by immersion in the above stripping solutions, film side down until all resist was removed from the wafer. The minimum stripping time (MST in minutes:seconds) and rate of removal (in microns per minute) for each was observed to be as follows:

| | NMP | NMP + NHEP | NHEP |
|---|---|---|---|
| MST | 5.0 | 1.0 | 1.0:40 |
| Rate | 0.2 | 1.0 | 0.6 |

Example 2

A series of stripping solutions were prepared according to the present invention consisting of N-(2-hydroxyethyl)-2-pyrrolidone (NHEP) in N-methyl-2-pyrrolidone (NMP) where, for each test, the NMP was present in a different concentration.

Each solution was maintained at approximately 80°C during stripping. Silicon wafers prepared as in Example 1, were stripped in each of these solutions. The observed minimum stripping times for each solution are shown in the following table:

| Solution Number | NHEP (%) | NMP (%) | Min. Stripping Time (Minutes:Seconds) |
|---|---|---|---|
| 1 | 0 | 100 | 5:00 |
| 2 | 5 | 95 | 1:00 |
| 3 | 10 | 90 | 1:05 |
| 4 | 15 | 85 | 1:10 |
| 5 | 20 | 80 | 1:10 |
| 6 | 30 | 70 | 1:20 |
| 7 | 40 | 60 | 1:25 |
| 8 | 60 | 40 | 1:30 |
| 9 | 80 | 20 | 1:35 |
| 10 | 100 | 0 | 1:40 |

Example 3

The procedure of Example 2 was repeated except that N-cylohexyl-pyrrolidone (NCP) was substituted for the N-(2-hydroxyethyl)-2-pyrrolidone. The results are set forth in the following table:

| Solution Number | NCP (%) | NMP (%) | Min. Stripping Time (Minutes:Seconds) |
|---|---|---|---|
| 1 | 0 | 100 | 9:30 |
| 2 | 10 | 90 | 8:00 |
| 3 | 20 | 80 | 7:30 |
| 4 | 40 | 60 | 8:00 |
| 5 | 60 | 40 | 9:00 |
| 6 | 80 | 20 | 11:00 |
| 7 | 100 | 0 | 12:25 |

The stripping times set forth above are higher than those typically obtained. For example, compare the results using 100% NMP in these examples with those obtained using 100% NMP in the earlier examples. The difference in the results is a consequence of the samples of these examples having a prolonged post bake.

**Claims**

1. A stripper for positive working photoresist comprising a solution of a mixture of lactams where a first lactam is present in a concentration of at least 60 percent by weight of the stripping composition and one or more additional lactams, differing from the first lactam, comprises the balance of the lactams.

2. The stripper of Claim 1 where the lactams conform to the structural formula:

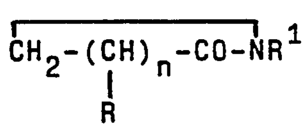

where n is a whole integer ranging from 1 to 3, each R substituted on a methylene group is selected from the group of hydrogen, a polar group, lower alkyl including cycloalkyl, and lower alkyl including cycloalkyl having polar group substitution, and $R^1$ is selected from the same group as R and aryl.

3. The stripper of Claim 1 where each lactam is a pyrrolidone.

4. The stripper of Claim 1 at essentially neutral pH.

5. The stripper of Claim 3 where the first pyrrolidone is present in a volume concentration of from 90 to 99 percent of the pyrrolidones and the second pyrrolidone comprises the balance of the pyrrolidones.

6. The stripper of Claim 3 where the first pyrrolidone is N-methyl-2-pyrrolidone.

7. The stripper of Claim 6 where the second pyrrolidone is selected from the group of N-(2-hydroxyethyl)-2-pyrrolidone and N-isopropyl-2-pyrrolidone.

8. A method of stripping a positive working photoresist from a substrate comprising contacting said resist with the stripper of any one of claims 1 to 7.

9. The method of Claim 8 where contact is by immersion of the photoresist in the stripping composition.

10. The method of Claim 8 where contact is by spraying the photoresist with the stripping composition.

11. The method of Claims 9 or 10 where the stripping composition is at room temperature.

12. The method of Claims 9 or 10 where the stripping composition is at an elevated temperature.

**Patentansprüche**

1. Mittel zum Entfernen von positiv arbeitendem Photolack, umfassend eine Lösung aus einem Gemisch von Lactamen, worin ein erstes Lactam in einer Konzentration von mindestens 60 Gew.-% der Entfernerzusammensetzung vorliegt und eines oder mehrere zusätzliche Lactame, die sich vom ersten Lactam unterscheiden, den Rest der Lactame ausmachen.

2. Photolackentferner nach Anspruch 1, worin die Lactame der Strukturformel

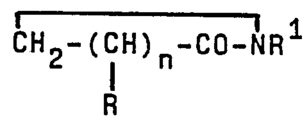

entsprechen, worin n eine ganze Zahl von 1 bis 3 ist, jeder an eine Methylengruppe gebundene Substituent R aus der aus Wasserstoff, einer polaren Gruppe, Niedrigalkyl, einschließlich Cycloalkyl und mit einer polaren Gruppe substituiertes Niedrigalkyl, einschließlich Cycloalkyl, bestehenden Gruppe ausgewählt ist und $R^1$ aus derselben Gruppe wie R und Aryl ausgewählt ist.

3. Photolackentferner nach Anspruch 1, worin jedes Lactam ein Pyrrolidon ist.

4. Photolackentferner nach Anspruch 1 mit im wesentlichen neutralem pH-Wert.

5. Photolackentferner nach Anspruch 3, worin das erste Pyrrolidon in einer Volumkonzentration von 90 bis 99% der Pyrrolidone vorliegt und das zweite Pyrrolidon den Rest der Pyrrolidone ausmacht.

6. Photolackentferner nach Anspruch 3, worin das erste Pyrrolidon N-Methyl-2-pyrrolidon ist.

7. Photolackentferner nach Anspruch 6, worin das zweite Pyrrolidon aus der aus N-(2-Hydroxyethyl)-2-pyrrolidon und N-Isopropyl-2-pyrrolidon bestehenden Gruppe ausgewählt ist.

8. Verfahren zum Entfernen eines positiv arbeitenden Photolacks von einem Substrat, bei dem der Photolack mit dem Photolackentferner gemäß einem der Ansprüche 1 bis 7 behandelt wird.

9. Verfahren nach Anspruch 8, bei dem die Behandlung durch Eintauchen des Photolacks in die Entfernerzusammensetzung erfolgt.

10. Verfahren nach Anspruch 8, bei dem die Behandlung durch Besprühen des Photolacks mit der Entfernerzusammensetzung erfolgt.

11. Verfahren nach Anspruch 9 oder 10, bei dem die Entfernerzusammensetzung Raumtemperatur aufweist.

12. Verfahren nach Anspruch 9 oder 10, bei dem die Entfernerzusammensetzung eine erhöhte Temperatur aufweist.

**Revendications**

1. Décapant pour couches de photoréserve à action positive comprenant une solution d'un mélange de lactames où un premier lactame est présent à une concentration d'au moins 60% en poids de la composition de dépouillement et un ou plusieurs lactames additionnels, différents du premier lactames, constitue(nt) le reste des lactames.

2. Agent de dépouillement de la revendication 1, dans lequel les lactames se conforment à la formule développée:

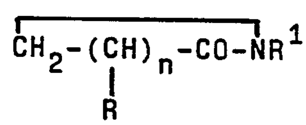

où n est un nombre entier allant de 1 à 3, chacun des radicaux R substitués sur un groupe méthylène est choisi dans le groupe constitué par l'hydrogène, un groupe polaire, un alcoyle inférieur y compris un cyclo-alcoyle ayant un groupe de substitution polaire, et $R^1$ est choisi dans le même groupe que R et aryle.

3. Décapant selon la revendication 1 dans lequel chacun des lactames est une pyrrolidone.

4. Décapant selon la revendication 1 à un pH sensiblement neutre.

5. Décapant selon la revendication 3 dans lequel la première pyrrolidone est présente en une concentration volumique allant de 90 à 99% des pyrrolidones et la seconde pyrrolidone constitue le reste des pyrrolidones.

6. Décapant selon la revendication 3 dans lequel la première pyrrolidone est la N-méthyl-2-pyrrolidone.

7. Décapant selon la revendication 6 dans lequel la seconde pyrrolidone est choisie dans le groupe constitué par la N-(2-hydroxyéthyl)-2-pyrrolidone et la N-isopropyl-2-pyrrolidone.

8. Procédé pour décaper une couche de photoréserve à action positive à partir d'un substrat, dans lequel on met en contact ladite photoréserve avec le décapant selon l'une quelconque des revendications 1 à 7.

9. Procédé selon la revendication 8 dans lequel le contact se fait par immersion de la photoréserve dans la composition décapante.

10. Procédé selon la revendication 8 dans lequel le contact se fait par pulvérisation de la composition décapante sur la photoréserve.

11. Procédé selon les revendications 9 ou 10 dans, lequel la composition décapante est à la température ambiante.

12. Procédé selon les revendications 9 ou 10 dans lequel la composition décapante est à une température élevée.